# FASCICULE DE BREVET EUROPEEN

(11) **EP 1 677 338 B1**
(45) Date de publication et mention de la délivrance du brevet: **27.07.2016**
(21) Numéro de dépôt: 05111324.9
(22) Date de dépôt: 25.11.2005
(51) Int. Cl.: H01J 37/32, H01L 21/3065

(54) **Dispositif et procédé pour le contrôle de la profondeur de gravure lors de la gravure alternée par plasma de substrats semi-conducteurs**
Vorrichtung und Verfahren zum Kontrollieren der Ätztiefe während des abwechselnden Plasmaätzens von Halbleitersubstraten
Apparatus and method for controlling etch depth during plasma alternating etching of semiconductor substrates

(30) Priorité: 31.12.2004 FR 0453276
(43) Date de publication de la demande: 05.07.2006
(73) Titulaire: Tegal Corporation, Petaluma, CA 94952 (US)
(72) Inventeur: Puech, Michel, 74370, Metz-Tessy (FR); Launay, Nicolas, 74000, Annecy (FR)
(74) Mandataire: Santarelli

(56) Documents cités:
- EP-A- 1 420 438
- EP-A2- 0 352 740
- US-A1- 2004 200 574
- US-B1- 6 200 822
- US-B1- 6 526 355
- US-B1- 6 720 268
- DATABASE INSPEC [en ligne] THE INSTITUTION OF ELECTRICAL ENGINEERS, STEVENAGE, GB Mars 1983 STERNHEIM M ET AL: 'A laser interferometer system to monitor dry etching of patterned silicon' Database accession no. 2063564 & JOURNAL OF THE ELECTROCHEMICAL SOCIETY USA vol. 130, no. 3, pages 655 - 658 ISSN: 0013-4651

## Description

La présente invention concerne le domaine du micro-usinage de substrats semi-conducteurs pour la réalisation de composants de microsystèmes électromécaniques (MEMS) ou de microsystèmes électrooptomécaniques (MOEMS). Elle se rapporte plus particulièrement au contrôle de la profondeur de gravure lors du microusinage du silicium par plasma par la technique de gravure alternée, notamment au dispositif et au procédé utilisé.

Les circuits intégrés sont fabriqués dans la masse de plaquettes de matériau semiconducteur. Des tracés sont reproduits à la surface de la plaquette selon un motif en forme de grille, de telle sorte que les circuits imprimés individuels, appelés "chips", puissent être aisément séparés les uns des autres. Une fois le traitement de la plaquette terminé, on réalise une découpe le long du tracé afin d'individualiser les "chips".

La plupart des applications utilisant des composants gravés sur des substrats de silicium nécessitent une extrême précision du motif gravé, notamment de sa profondeur. Il s'agit donc pour maîtriser précisément cette profondeur de déterminer sans ambiguïté la fin de l'opération de gravure. Les méthodes les plus répandues de détection de la fin de l'opération de gravure sont des méthodes faisant appel à des techniques optiques (US-6,200,822).

Une méthode consiste à envoyer un faisceau lumineux de fréquence uniforme, de préférence un faisceau laser, sur un substrat à graver comportant deux couches distinctes dont l'indice de réfraction est différent. Le faisceau y est réfléchi, puis recueilli par un détecteur. Un changement brusque de l'intensité lumineuse détectée, due au changement d'indice de réfraction en passant d'une couche à une autre, indique la fin de la gravure,

On a aussi proposé l'utilisation d'une méthode basée sur l'interférométrie laser. Selon cette méthode, on envoie un faisceau monochromatique généré par un laser sensiblement perpendiculairement sur une couche à graver semi-transparente. Le faisceau réfléchi partiellement est recueilli par un photo-détecteur approprié. Les faisceaux issus de la réflexion sur la surface de la couche de SiO2 d'une part et sur l'interface de cette couche avec le substrat d'autre part interfèrent pour donner une courbe sinusoïdale caractéristique. Le phénomène d'interférence est gouverné par la loi d = λ / 2n où d est l'épaisseur de la couche à graver, λ est la longueur d'onde du faisceau et n est l'indice de réfraction du milieu de propagation (n = 1 dans le vide ). L'aplatissement de la courbe indique que la couche semi-transparente a été complètement consommée, donc la fin de l'opération de gravure.

Un autre document décrit un dispositif de contrôle de l'opération de gravure par plasma d'un substrat semi-conducteur. La chambre de traitement comporte deux fenêtres couplées à un spectromètre pour permettre d'observer le plasma. Chaque spectromètre fournit un signal calé sur la longueur d'onde d'une espèce sélectionnée de la radiation de décharge électroluminescente. La première fenêtre, observant dans un plan parallèle à la surface du substrat, fournit un signal relatif à la variation d'intensité pendant la gravure d'une longueur d'onde sélectionnée. La seconde fenêtre, observant dans un plan normal à la surface du substrat, donne un signal contenant des informations relatives à la variation d'intensité de la longueur d'onde sélectionnée et à la variation de réflectivité de la couche de SiO2 qui se redépose de manière continue au cours du traitement. Par interférométrie, on obtient un signal relatif à la variation d'intensité dans le temps de la réflectivité de la surface de la plaquette, donc de l'épaisseur de la couche de SiO2 qui en dépend directement. Des moyens permettent d'en déduire la profondeur de la gravure et l'épaisseur de la couche de SiO2.

Le micro-usinage de silicium par plasma ou "DRIE" (pour "Deep Reactive Ion Etching" en anglais) utilise le plus couramment actuellement une technique dite de gravure alternée qui est caractérisée par l'alternance d'étapes d'enlèvement et de dépôt qui se succèdent très rapidement. Cette méthode est notamment décrite dans le document

US 5,501,893. Cette technique consiste à occulter partiellement le substrat de silicium par un masque, et à soumettre le substrat occulté à une succession alternée d'étapes d'attaque par plasma de gaz de gravure et d'étapes de passivation par plasma de gaz de passivation. Au cours de chaque étape d'attaque, le plasma de gaz de gravure tel que l'hexafluorure de soufre SF6 réalise des cavités dans les zones de substrat non occultées par le masque. Au cours de chaque étape de passivation, le plasma de gaz de passivation tel qu'un gaz fluorocarboné, par exemple C4F8, dépose sur la paroi de la cavité un film polymère protecteur. Chacune des étapes d'attaque et de passivation a une durée très courte, de quelques secondes, et la passivation évite que le plasma de gaz de gravure attaque la paroi latérale de la cavité au cours de l'étape d'attaque ultérieure. Il en résulte que l'attaque se fait sélectivement dans le fond de la cavité, après que le plasma de gaz de gravure ait enlevé le film de polymère protecteur dans le fond de la cavité. Ainsi, malgré le caractère isotrope de l'attaque du silicium par un plasma de gaz de gravure tel qu'un gaz fluoré, on obtient une gravure quasi anisotrope, rapide et sélective du silicium.

Les méthodes de détection par techniques optiques de la fin de l'opération de gravure des procédés antérieurs (US-6,526,355) ne sont plus utilisables dans ce procédé de gravure alternée car les informations fournies sont perturbées par l'alternance et donc inexploitables.

Le problème posé par la présente invention est de perfectionner le dispositif et le procédé de gravure alternée du silicium par succession d'étapes d'attaque et d'étapes de passivation, de manière à assurer une maîtrise améliorée de la profondeur de gravure d'un substrat semi-conducteur.

L'invention a pour but de proposer un dispositif de contrôle de la fin d'une opération de gravure par plasma sur un substrat lorsque la profondeur souhaitée est atteinte. L'invention a aussi pour but de proposer un procédé qui permette de déterminer de manière certaine et précise la fin de l'opération de gravure.

L'objet de la présente invention est un dispositif de contrôle selon la revendication 1.

Selon un premier mode de réalisation de l'invention le moyen d'émission comprend un laser à Hélium-Néon qui génère un signal monochromatique ayant une longueur d'onde de 632,8nm. De préférence le moyen d'émission comprend en outre un miroir semi-réfléchissant. Le miroir permet de réfléchir le faisceau émis par le laser en direction du substrat et de laisser passer le faisceau réfléchi par le substrat vers le détecteur.

Selon un deuxième mode de réalisation, le deuxième moyen de détection comprend un interféromètre.

Selon un troisième mode de réalisation, le premier moyen de détection comprend un spectromètre d'émission.

Selon un quatrième mode de réalisation, le plan de la deuxième fenêtre est sensiblement perpendiculaire à celui de la première fenêtre.

L'invention a aussi pour objet un procédé de contrôle de l'opération de gravure par plasma de la surface d'un substrat semiconducteur par la méthode de gravure alternée au moyen du dispositif précédent, comprenant les étapes suivantes:
- on génère un signal monochromatique,
- on envoie le signal sur le substrat selon une direction sensiblement perpendiculaire à sa surface à graver,
- on détecte le signal réfléchi sur le substrat,
- on détecte un signal lié à la présence dans le plasma d'une espèce issue de la réaction du gaz de gravure avec le substrat,
- on extrait du signal réfléchi les parties du signal correspondant à la présence de l'espèce pour obtenir une courbe représentative des seules étapes de gravure. Selon une forme d'exécution de l'invention, le substrat est du silicium et l'espèce dont on détecte la présence lors de l'étape d'enlèvement de matière est une espèce de type SiFx, comme SiF4 par exemple.

Selon une autre forme d'exécution de l'invention, le substrat est du silicium et l'espèce dont on détecte la présence lors de l'étape d'enlèvement de matière est une espèce de type CFx, comme CF2 par exemple.

La présente invention a comme avantage de permettre d'obtenir un signal qui correspond exclusivement aux périodes où s'effectue réellement la gravure, et par conséquent qui fournit des informations directement exploitables.

D'autres caractéristiques et avantages de la présente invention apparaîtront à la lecture de la description suivante d'un mode de réalisation, donné bien entendu à titre illustratif et non limitatif, et dans le dessin annexé sur lequel la figure unique illustre schématiquement un dispositif de gravure dans lequel est mis en oeuvre le procédé selon la présente invention.

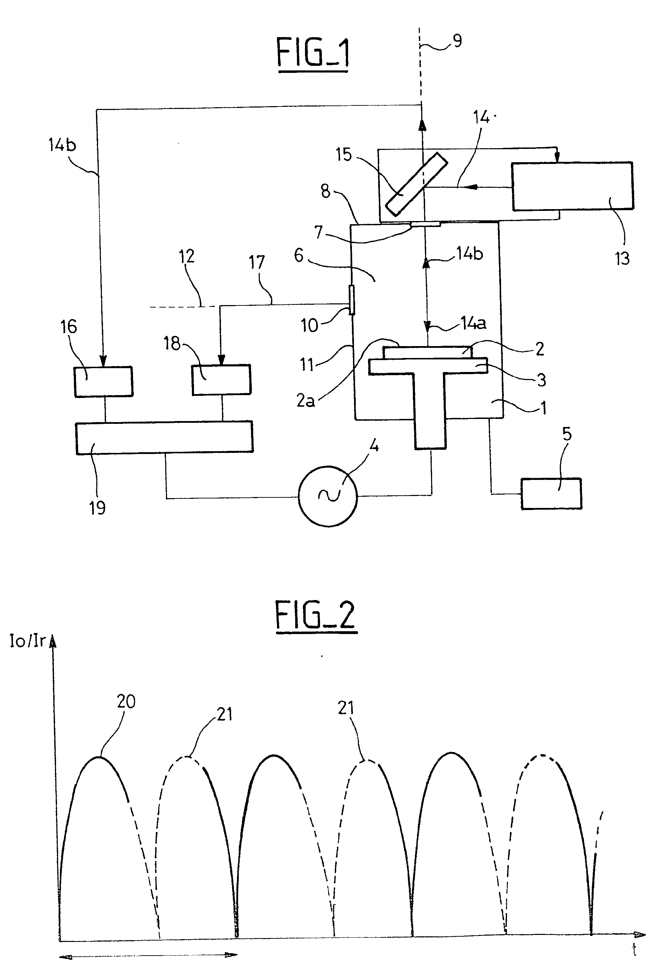

Dans le mode de réalisation illustré sur la figure 1, l'installation de micro-usinage de substrats semi-conducteurs comprend une enceinte 1 étanche, conformée pour recevoir et contenir un substrat semi-conducteur 2 à graver.

De manière connue, le substrat 2, par exemple une plaquette de silicium, est fixé sur un support 3 polarisé négativement par rapport à la masse par un moyen de polarisation 4. Un moyen de génération de vide 5, relié à la chambre de procédé 1 et comprenant par exemple une pompe primaire et une pompe secondaire, permet de créer et de maintenir un vide approprié dans l'enceinte 1. Le substrat 2 est orienté dans la chambre 1 de façon que sa surface 2a à travailler soit apparente. Face à la surface 2a à usiner, se trouvent un moyen pour générer un plasma 6 dirigé vers la surface 2a à usiner. L'installation comporte un moyen pour injecter sélectivement des gaz dans la chambre 1, notamment des gaz de gravure et des gaz de passivation. Pendant les étapes de gravure on introduit par exemple SiF6 comme gaz de gravure, le plasma 6 contient des atomes actifs électriquement neutres tels que des atomes de fluor F, qui se propagent en toutes directions, et des ions tels que SF5+ qui se trouvent attirés par le substrat 2 polarisé et attaquent le silicium. Pendant les étapes de passivation, on introduit un gaz fluorocarboné, tel que CHF3, C2F6, C2F4 ou C4F8, qui génère la formation d'un film polymère protecteur sur toute la surface gravée.

Selon la présente invention l'enceinte 1 comporte une première fenêtre 7 en quartz placée sur une première paroi 8 qui fait face à la surface à graver 2a de manière à observer la surface à graver 2a selon un axe 9 qui lui est sensiblement perpendiculaire, et une seconde fenêtre 10 disposée sur une seconde paroi 11, ici perpendiculaire à la première paroi 8, de manière à observer le plasma 6 selon un axe 12, ici sensiblement parallèle à la surface à graver 2a.

Selon l'invention, l'installation comporte en outre un moyen 13 de génération d'un signal optique monochromatique, comme par exemple une diode laser ou de préférence un laser Hélium-Néon. Le signal optique 14 émis par le laser 13 est dirigé à l'aide d'un miroir semi-réfléchissant 15 vers la surface 2a du substrat 2 à travers la fenêtre 7. Le signal incident 14a se réfléchit sur la surface 2a en cours de gravure, et le signal réfléchi 14b quasi totalement réfléchi repart sensiblement par le même chemin dans la direction inverse. Après avoir traversé la fenêtre 7, puis le miroir semi-réfléchissant 15, le signal réfléchi 14b est dirigé vers un moyen de détection 16, comme un interféromètre, au moyen d'une fibre optique par exemple. L'émission et la détection du signal laser sont effectuées pendant toute la durée de l'opération du traitement par gravure alternée du substrat.

Selon l'invention, l'installation comporte aussi un moyen d'observation du plasma 6. Le signal optique 17 provenant de l'observation du plasma 6 à travers la fenêtre 10 est dirigé, au moyen d'une fibre optique par exemple, vers un spectromètre d'émission 18 qui analyse le signal 17 afin d'identifier la présence d'espèces issues de la réaction du gaz de gravure avec le substrat 2, notamment la présence de SiF4 dans le cas de la réaction de SiF6 avec le silicium.

Un moyen 19 de transformation du signal, tels qu'un calculateur, extrait du signal reçu par le détecteur 16 les périodes durant lesquelles le spectromètre 18 a détecté la présence d'espèces issues de la réaction du gaz de gravure avec le substrat 2, notamment SiF4. On obtient alors un signal d'interférométrie laser 20 reconstitué qui est présenté sur la figure 2 et qui correspond exclusivement aux périodes effectives de gravure du substrat, à l'exclusion des périodes 21 de passivation, et éventuellement de dépassivation.

Sur la figure 2, le signal reconstitué 20 se présente comme la variation en fonction du temps du rapport Io/Ir, où Io est l'intensité du signal 12 émis par le laser et Ir est l'intensité du signal réfléchi 12b reçu par le détecteur 14. La distance d est fonction de la longueur d'onde λ du laser et de l'indice de réfraction n du milieu de propagation (ici le vide n=1) d = λ / 2n et représente l'épaisseur de la couche à graver. Le calculateur 19 détermine à partir de l'analyse du signal 20 la fin de l'opération de gravure.

Par exemple, si le substrat comporte une couche de silicium Si placée au-dessus d'une fine couche de SiO2 enterrée, et si l'opération de gravure consiste à graver totalement la couche superficielle de silicium Si en s'arrêtant à la surface du SiO2, alors le signal 20 présentera un aplatissement lorsque l'interface Si/SiO2 sera atteint.

Si le substrat de silicium est homogène et si l'opération de gravure consiste à graver le silicium sur une profondeur déterminée, il sera alors possible d'estimer à partir du signal 20 la profondeur gravé ainsi que la vitesse de gravure quasi-instantanée Vi en mesurant le temps t écoulé entre deux extrema selon la loi Vi = d/t = λ/2nt.

La présente invention n'est pas limitée aux modes de réalisation qui ont été explicitement décrits, mais elle est définie par les revendications.

## Revendications

1. Dispositif de contrôle de l'opération de gravure par plasma d'un substrat semiconducteur par la méthode de gravure alternée, comportant
- une chambre de procédé (1) dans laquelle est traité ledit substrat (2),
- un moyen de génération d'un plasma (6),
- au moins une première fenêtre (7) ménagée dans une première paroi (8) de ladite chambre (1) faisant face à la surface à graver (2a) dudit substrat (2),
- au moins une deuxième fenêtre (10) ménagée dans une deuxième paroi (11) de ladite chambre (1) disposée dans un plan différent de ladite première paroi (8),
- un premier moyen (18) couplé à ladite deuxième fenêtre (10) configuré afin de détecter un signal optique (17) relatif à une longueur d'onde sélectionnée émise par ledit plasma (6), ledit dispositif comprenant en outre
- un moyen d'émission (13, 15) d'un signal optique monochromatique (14) au travers de ladite première fenêtre (7) vers ladite surface (2a), selon une direction (9) sensiblement perpendiculaire à ladite surface (2a), de manière à ce que ledit signal incident (14a) se réfléchisse sur ladite surface (2a),
- un deuxième moyen (16) configuré afin de détecter ledit signal réfléchi (14b), et
- un moyen de transformation (19), couplé audit premier moyen (18) et audit deuxième moyen (16), configuré afin de transformer le signal détecté par ledit deuxième moyen (16) en fonction du signal détecté par ledit premier moyen (18) en sorte d'obtenir un signal qui correspond exclusivement aux périodes où s'effectue réellement la gravure.

2. Dispositif selon la revendication 1, dans lequel ledit moyen d'émission comprend un laser à Hélium-Néon.

3. Dispositif selon la revendication 1, dans lequel ledit moyen d'émission comprend une diode laser.

4. Dispositif selon l'une des revendications 2 et 3, dans lequel ledit moyen d'émission comprend un miroir semi-réfléchissant (15).

5. Dispositif selon l'une des revendications précédentes, dans lequel ledit deuxième moyen (16) de détection comprend un interféromètre.

6. Dispositif selon l'une des revendications précédentes, dans lequel ledit premier moyen (16) de détection comprend un spectromètre d'émission.

7. Dispositif selon l'une des revendications précédentes, dans lequel le plan de ladite deuxième fenêtre (10) est sensiblement perpendiculaire à celui de ladite première fenêtre (7).

8. Procédé de contrôle de l'opération de gravure par plasma (6) de la surface (2a) d'un substrat semiconducteur (2) par la méthode de gravure alternée au moyen du dispositif selon l'une des revendications précédentes, comprenant les étapes suivantes:
- on génère un signal monochromatique (14)
- on envoie ledit signal (14a) sur le substrat (2) selon une direction sensiblement perpendiculaire à sa surface (2a) à graver,
- on détecte ledit signal (14b) réfléchi sur ledit substrat (2),
- on détecte un signal (17) lié à la présence dans le plasma (6) d'une espèce issue de la réaction du gaz de gravure avec ledit substrat (2),
- on extrait dudit signal réfléchi (14b) les parties du signal correspondant à la présence de ladite espèce pour obtenir une courbe (20) représentative des seules étapes de gravure.

9. Procédé selon la revendication 8, dans lequel ledit substrat est du silicium et ladite espèce est de type SiFx.

10. Procédé selon la revendication 8, dans lequel ledit substrat est du silicium et ladite espèce est de type CFx.

## Patentansprüche

1. Vorrichtung zum Steuern des Plasmaätzvorgangs an einem Halbleitersubstrat über das abwechselnde Ätzverfahren, enthaltend
- eine Verfahrenskammer (1), in der das Substrat (2) behandelt wird,
- eine Einrichtung zum Erzeugen eines Plasmas (6),
- zumindest ein erstes Fenster (7), das in eine erste Wand (8) der Kammer (1) eingebracht ist, die der zu ätzenden Fläche (2a) des Substrats (2) gegenüberliegt,
- zumindest ein zweites Fenster (10), das in eine zweite Wand (11) der Kammer (1) eingebracht ist, die in einer anderen Ebene als die erste Wand (8) angeordnet ist,
- eine erste Einrichtung (18), die mit dem zweiten Fenster (10) gekoppelt und dazu ausgelegt ist, ein optisches Signal (17) bezüglich einer ausgewählten Wellenlänge zu erfassen, die von dem Plasma (6) ausgegeben wird, wobei die Vorrichtung ferner aufweist:
- eine Sendeeinrichtung (13, 15) zum Senden eines monochromatischen optischen Signals (14) durch das erste Fenster (7) hindurch an die Fläche (2a) in einer im Wesentlichen senkrecht zur Fläche (2a) verlaufenden Richtung (9), so dass das ankommende Signal (14a) an der Fläche (2a) reflektiert wird,
- eine zweite Einrichtung (16), die dazu ausgelegt ist, das reflektierte Signal (14b) zu erfassen, und
- eine Umwandlungseinrichtung (19), die mit der ersten Einrichtung (18) und mit der zweiten Einrichtung (16) gekoppelt und dazu ausgelegt ist, das von der zweiten Einrichtung (16) erfasste Signal in Abhängigkeit von dem von der ersten Einrichtung (18) erfassten Signal umzuwandeln, so dass ein Signal erhalten wird, das ausschließlich den Zeitspannen entspricht, wo das Ätzen tatsächlich erfolgt.

2. Vorrichtung nach Anspruch 1, wobei die Sendeeinrichtung einen Helium-Neon-Laser aufweist.

3. Vorrichtung nach Anspruch 1, wobei die Sendeeinrichtung eine Laser-Diode aufweist.

4. Vorrichtung nach einem der Ansprüche 2 und 3, wobei die Sendeeinrichtung einen halbdurchlässigen Spiegel (15) aufweist.

5. Vorrichtung nach einem der vorangehenden Ansprüche, wobei die zweite Erfassungseinrichtung (16) ein Interferometer aufweist.

6. Vorrichtung nach einem der vorangehenden Ansprüche, wobei die erste Erfassungseinrichtung (18) ein Emissionsspektrometer aufweist.

7. Vorrichtung nach einem der vorangehenden Ansprüche, wobei die Ebene des zweiten Fensters (10) im Wesentlichen senkrecht zu der des ersten Fensters (7) verläuft.

8. Verfahren zum Steuern des Ätzvorgangs mittels Plasmas (6) an der Fläche (2a) eines Halbleitersubstrats (2) durch das abwechselnde Ätzverfahren mit Hilfe der Vorrichtung nach einem der vorangehenden Ansprüche, umfassend die nachfolgenden Schritte:
- Erzeugen eines monochromatischen Signals (14),
- Senden des Signals (14a) an das Substrat (2) in einer im Wesentlichen senkrecht zu seiner zu ätzenden Fläche (2a) verlaufenden Richtung,
- Erfassen des an dem Substrat (2) reflektierten Signals (14b),
- Erfassen eines Signals (17), das mit dem Vorhandensein einer Spezies im Plasma (6) zusammenhängt, die bei der Reaktion von Ätzgas mit dem Substrat (2) entsteht,
- Extrahieren der Signalteile aus dem reflektierten Signal (14b), die dem Vorhandsein der Spezies entsprechen, um eine allein für die Ätzschritte repräsentative Kurve (20) zu erhalten.

9. Verfahren nach Anspruch 8, wobei das Substrat Silicium ist und die Spezies vom Typ SiFx ist.

10. Verfahren nach Anspruch 8, wobei das Substrat Silicium ist und die Spezies vom Typ CFx ist.

## Claims

1. A device for controlling the operation of plasma etching a semiconductor substrate by the alternating etching method, comprising:
- a process chamber (1) in which said substrate (2) is processed,
- means for generating a plasma (6),
- at least one first window (7) formed in a first wall (8) of said chamber (1) facing the surface to be etched (2a) of said substrate (2),
- at least one second window (10) formed in a second wall (11) of said chamber (1) lying in a plane different from said first wall (8),
- a first means (18) coupled to said second window (10) configured to detect an optical signal (17) relating to a selected wavelength emitted by said plasma (6), said device further comprising
- a means (13, 15) for emitting a monochromatic optical signal (14) through said first window (7) towards said surface (2a), in a direction (9) substantially perpendicular to said surface (2a) in such a manner that said incident signal (14a) is reflected on said surface(2a),
- a second means (16) configured for detecting said reflected signal (14b), and
- a transformation means (19), coupled to said first means (18) and to said second means (16) configured to transform the signal detected by said second means (16) as a function of the signal detected by said first means (18) so as to obtain a signal which exclusively corresponds to the periods in which the etching is really carried out.

2. A device according to claim 1, in which said emitter means comprises a helium-neon laser.

3. A device according to claim 1, in which said emitter means comprises a laser diode.

4. A device according to one of claims 2 and 3, in which said emitter means include a semi-reflecting mirror (15).

5. A device according to any one of the preceding claims, in which said second detector means (16) comprise an interferometer.

6. A device according to one of the preceding claims, in which said first detector means (18) comprises an emission spectrometer.

7. A device according to one of the preceding claims, in which the plane of said second window (10) is substantially perpendicular to the plane of said first window (7).

8. A method of controlling the operation of plasma etching (6) the surface (2a) of a semiconductor substrate (2) by the alternating etching method using a device according to one of the preceding claims, comprising the following steps:
- generating a monochromatic signal (14),
- sending said signal (14) to the substrate (2) in a direction substantially perpendicular to the surface (2a) to be etched,
- detecting said signal (14b) reflected on said substrate (2),
- detecting a signal (17) linked to the presence in the plasma (6) of a species arising from the reaction of the etching gas with said substrate (2),
- extracting from said reflected signal (14b) those portions of the signal that correspond to the presence of said species in order to obtain a curve (20) representing the etching steps alone.

9. A method according to claim 8, in which said substrate is of silicon and said species is of the type SiFx.

10. A method according to claim 8, in which said substrate is of silicon and said species is of the type CFx.
